Europäisches Patentamt

European Patent Office

Office européen des brevets

(11) Veröffentlichungsnummer: **0 410 189 A1**

# EUROPÄISCHE PATENTANMELDUNG

(21) Anmeldenummer: 90113000.5

(22) Anmeldetag: 07.07.90

(51) Int. Cl.5: **H03K 3/017**, H03K 7/08, H02P 7/00

(30) Priorität: 26.07.89 DE 3924652

(43) Veröffentlichungstag der Anmeldung:
30.01.91 Patentblatt 91/05

(84) Benannte Vertragsstaaten:
DE FR GB IT SE

(71) Anmelder: TELEFUNKEN electronic GmbH
Theresienstrasse 2
D-7100 Heilbronn(DE)

(72) Erfinder: Sedlmeier, Reinhold
Rottenegger Strasse 24 1/2
D-8069 Niederlauterbach(DE)

(74) Vertreter: Maute, Hans-Jürgen, Dipl.-Ing.
TELEFUNKEN electronic GmbH
Theresienstrasse 2
D-7100 Heilbronn(DE)

(54) Pulsbreitenmodulator.

(57) Die Erfindung betrifft ein Verfahren zum Erzeugen eines pulsbreitenmodulierten Signals sowie eine Schaltungsanordnung zur Durchführung dieses Verfahrens. Das erfindungsgemäße Verfahren besteht darin, die in Abhängigkeit von einer Stellgröße erzeugten n-Bit-Steuerdaten mit dem von einem n-Bit-Zähler erzeugten Zählerstand zu vergleichen, wobei der Zählvorgang nach Erreichen des Höchstwertes erneut beim niedrigsten Wert beginnt. Das Ergebnis des "kleiner als"- oder "größer als"-Vergleichs stellt als digitales Signal im zeitlichen Verlauf das pulsbreitenmodulierte Signal dar. Die erfindungsgemäße Schaltungsanordnung umfaßt einen die n-Bit-Steuerdaten erzeugenden Mikroprozessor und den n-Bit-Zähler, die mit dem gleichen Taktsignal versorgt werden, sowie einen die n-Bit-Steuerdaten und den Zählerstand des n-Bit-Zählers vergleichenden digitalen Komparator, wobei am "kleiner als"- oder "größer als"-Ausgang des digitalen Komparators das pulsbreitenmodulierte Signal vorliegt.

FIG.3

EP 0 410 189 A1

## PULSBREITENMODULATOR

Die Erfindung betrifft ein Verfahren zum Erzeugen eines pulsbreitenmodulierten Signales sowie eine Schaltungsanordnung zur Durchführung dieses Verfahrens.

Zur Verbesserung der Leistungsregelung sowie zur Verminderung des Stromverbrauchs von elektrischen Verbrauchern werden zunehmend getaktete Steuerungen eingesetzt. So wird beispielsweise zur Drehzahlregelung eines Gleichstrommotors ein Leistungsschalter mit einem getakteten Spannungssignal mit fester Frequenz und variablem Puls-Pausenverhältnis angesteuert. Auch ein Relais kann zur Stromeinsparung mit einer getakteten Betriebsspannung versorgt werden.

Ein solches pulsbreitenmodulierte Signal (PWM-Signal) wird mittels eines RC-Oszillators und einem Schmitt-Trigger mit steuerbaren Triggerschwellen erzeugt, wobei der Schmitt-Trigger als Rechteckformer dient. Ein anderes Verfahren besteht darin, eine programmierbare Steuerspannung mit der Ausgangsspannung eines Dreiecksgenerators mittels eines Komparators zu vergleichen, wobei die Dreiecksspannung mittels der RC-Ladungskurve eines Kondensators erzeugt wird.

Die Steuerung der "getakteten" Verbraucher erfolgt meistens über eine Steuereinheit, beispielsweise einen Mikroprozessor, in Abhängigkeit der Abweichung von einem vorgegebenen Istwert, indem davon ein Stellwert von dieser Steuereinheit abgeleitet wird, der der das PWM-Signal erzeugenden Einheit zugeführt wird, wodurch sich das Puls-Pausenverhältnis ändert.

Der von der Steuereinheit erzeugte Stellwert liegt jedoch als digitaler Wert vor, so daß er, bevor er einem Schmitt-Trigger oder einem analogen Komparator zugeführt werden kann, analogisiert werden muß.

Der einem solchen System aus Steuereinheit, D/A-Wandler sowie PWM-Signal erzeugenden Einheit zugrunde liegende Nachteil besteht darin, daß nur ein PWM-Signal mit niedriger Frequenz und geringem Auflösungsvermögen erzeugt werden kann. Dies soll im folgenden anhand eines einfachen Zahlenbeispieles erläutert werden.

In der Regel beträgt die Frequenz eines PWM-Signales wenigstens 20 kHz, das entspricht einer Periodendauer von 50 μs. Für einen Ausgabebefehl eines Mikroprozessors mit einer Taktfrequenz von 10 MHz muß eine Dauer von ca. 2 μs veranschlagt werden. Daraus folgt, daß lediglich 25 verschiedene Puls-Pausenverhältnisse einstellbar sind.

Der vorliegenden Erfindung liegt daher die Aufgabe zugrunde, ein Verfahren zur Erzeugung eines hochfrequenten und hochauflösenden PWM-Signales anzugeben sowie eine Schaltungsanordung zur Durchführung dieses Verfahrens zu schaffen.

Diese Aufgabe wird gemäß den kennzeichnenden Merkmalen des Anspruches 1 sowie des Anspruches 2 gelöst.

Ein Vorteil der vorliegenden Erfindung besteht darin, daß sich ein hochauflösendes PWM-Signal erzeugen läßt und gleichzeitig hierzu eine langsame Steuereinheit, beispielsweise ein Mikroprozessor, verwenden läßt. Die Schaltfrequenz $f_{sch}$ des PWM-Signals errechnet sich nach folgender Formel:

$$f_{sch} = \frac{f_T}{2^n},$$

wobei $f_T$ die Taktfrequenz und n die Bitzahl des Zählers ist.

Vorteilhafte Ausführungsformen der Erfindung sind in den Unteransprüchen näher gekennzeichnet.

Im folgenden soll das erfindungsgemäße Verfahren anhand von Impuls-Diagrammen genauer erklärt sowie ein Ausführungsbeispiel der Schaltungsanordnung zur Durchführung dieses erfindungsgemäßen Verfahrens in Verbindung mit einer Zeichnung ausführlich erläutert werden. Es zeigen:

Figur 1 eine Tabelle zur Erläuterung des erfindungsgemäßen Verfahrens,

Figur 2 ein Beispiel eines gemäß dem erfindungsgemäßen Verfahren erzeugten PWM-Signales,

Figur 3 ein Blockschaltbild eines Ausführungsbeispieles einer Schaltungsanordnung zur Durchführung des erfindungsgemäßen Verfahrens, und

Figur 4 ein Anwendungsbeispiel für die Schaltungsanordnung gemäß Figur 3.

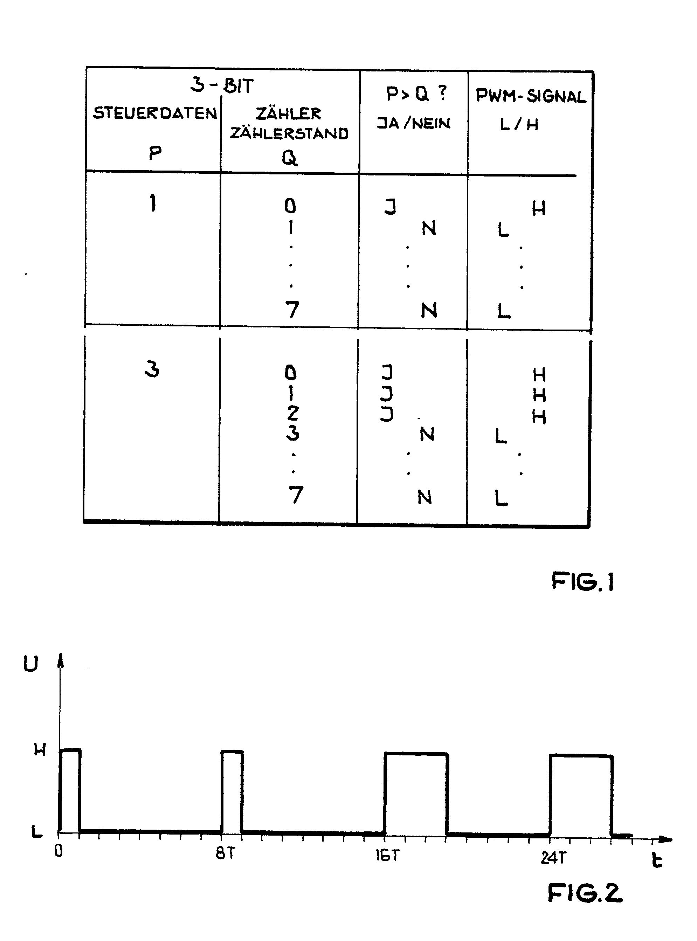

Zur Erläuterung des erfindungsgemäßen Verfahrens wird zwecks einfacherer und übersichtlicherer Darstellung eine Bit-Stellenzahl der Steuerdaten und des Zählers von n = 3 gewählt. Anhand der Tabelle der Figur 1 soll nun die Erzeugung eines pulsbreitenmodulierten Signales gemäß der Figur 2 erläutert werden.

Die in der ersten und zweiten Spalte aufgeführten Steuerdaten P bzw. Zählerstände Q sind zwecks Einfachheit als Dezimalzahlen und nicht als Binärzahlen dargestellt. Das erste Steuerwort ist also "1", der Zähler zählt sodann von "0" bis "7" hoch. Gemäß der Spalte 3 wird dieses Steuerwort P mit dem Zählwort Q verglichen, wobei in diesem Beispiel zu entscheiden ist, ob das Steuerwort P größer als das Zählwort Q ist, trifft also in diesem Beispiel nur für das Zählwort "0" zu. In der vierten Spalte werden nur entsprechend der vorangegangen Ja/Nein-Entscheidung ein Low- oder High-Pegel zugeordnet, nämlich der High-Pegel H für die "Ja"-Entscheidung und der Low-Pegel L für die "Nein"-Entscheidung. Wird diese Abfolge von High- und Low-Pegeln während der ersten acht Taktperioden im zeitlichen Verlauf aufgetragen, ergibt sich das Impuls-Diagramm gemäß Figur 2 für den Abszissenabschnitt 0 - 8T, wonach während der ersten Taktperiode ein High-Pegel H und während der zweiten bis achten Taktperiode ein Low-Pegel L ansteht. Das Puls-Pausenverhältnis beträgt hiernach 1/8. Der zeitliche Verlauf des Impuls-Signales während des Abszissenabschnittes von 8T - 16T entspricht dem davor liegenden, während in den nachfolgenden Zeitabschnitten von 16T - 24T bzw. 24T - 32T das Puls-Pausenverhältnis 3/8 beträgt. Die Erklärung für diesen Wert des Puls-Pausenverhältnisses ist wieder aus der Tabelle der Figur 1 zu ersehen, wonach das Steuerwort P eine "3" ist und der Zählerstand erst nach 3 Zählschritten diesen Wert erreicht.

Demnach wird während der ersten 3 Taktimpulsperioden ein H-Pegel und während der restlichen 5 Taktperioden ein L-Pegel erzeugt.

Das in Figur 2 gezeigte pulsbreitenmodulierte Signal weist somit 7 unterschiedliche Puls-Pausenverhältnisse, also Werte von 1/8 - 7/8 auf, wobei die Grenzwerte 0/8 und 8/8 nicht berücksichtigt sind.

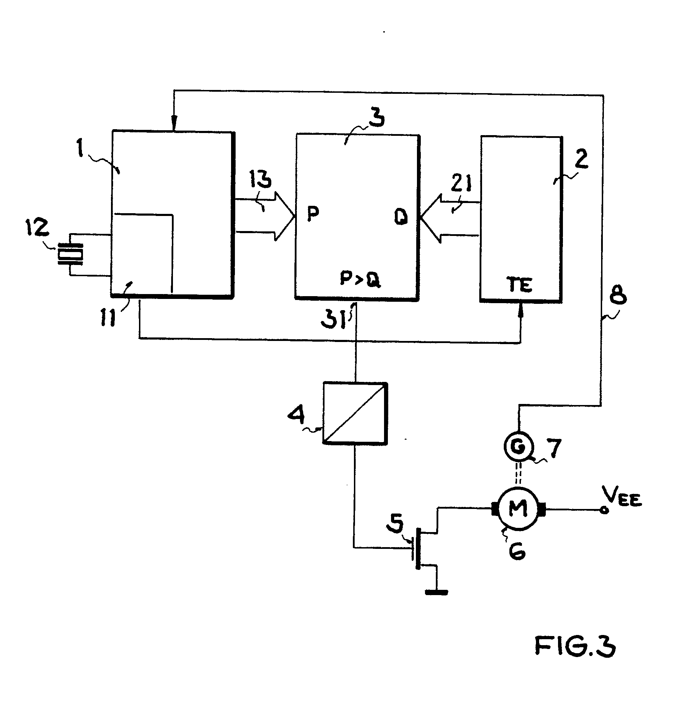

In der in Figur 3 dargestellten Schaltungsanordnung zur Durchführung des erfindungsgemäßen Verfahrens ist mit den Bezugszeichen 1 , 2 und 3 eine Steuereinheit, ein n-Bit-Zähler und ein digitaler Komparator bezeichnet. Die Steuereinheit 1 , beispielsweise ein Mikroprozessor, führt über eine Leitung 13 dem Komparator 3 ein n-Bit-Steuerwort P, das dieser Komparator 3 mit einem von dem Zähler 2 über die Leitung 21 zugeführten Zählwort Q vergleicht. Am Ausgang 31 des Komparators 3 liegt genau dann ein H-Pegel an, wenn das Steuerwort P größer als das Zählwort Q, also P > Q ist, ansonsten ein L-Pegel. An diesem Ausgang 31 ist also schon ein pulsbreitenmoduliertes Signal der Art gemäß Figur 2 abgreifbar.

Der Zähler 2 erhält über seinen Takteingang TE von dem einen Quarzoszillator 12 aufweisenden Taktgenerator 11 der Steuereinheit 1 die Taktimpulse, womit eine Synchronisation des Zählers 2 und Steuereinheit 1 sichergestellt ist.

Diese eben beschriebene Schaltungsanordnung wird gemäß dieser Figur 3 zur Drehzahlsteuerung eines Gleichstrommotors 6 eingesetzt, wonach ein Pegelkonverter 4 das ihm vom Ausgang 31 des Komparators 3 zugeführte pulsbreitenmodulierte Signal in zur Ansteuerung eines Leistungstransistors 5 geeignete Spannungspegel umsetzt.

Da der Leistungstransistor 5 in dem Laststromkreis des Gleichstrommotors 6 geschaltet ist, läßt sich die Drehzahl über das Puls-Pausenverhältnis des den Transistor 5 steuernden Signales beeinflussen. Beispielsweise bedeutet ein niedriger Wert des Puls-Pausenverhältnisses eine niedrige Drehzahl, dagegen ein hoher Wert eine hohe Drehzahl.

Über einen von dem Motor 6 angetriebenen Tachogenerator 7 wird über eine Leitung 8 die Ist-Drehzahl an die Steuereinheit 1 gemeldet, so daß dort eine Auswertung erfolgen kann, um beispielsweise mittels eines eingestellten Soll-Wertes davon die Abweichung des Ist-Wertes zu berechnen und hieraus zur Konstanthaltung der Drehzahl einen Stellwert in Form des Steuerwortes P auszugeben.

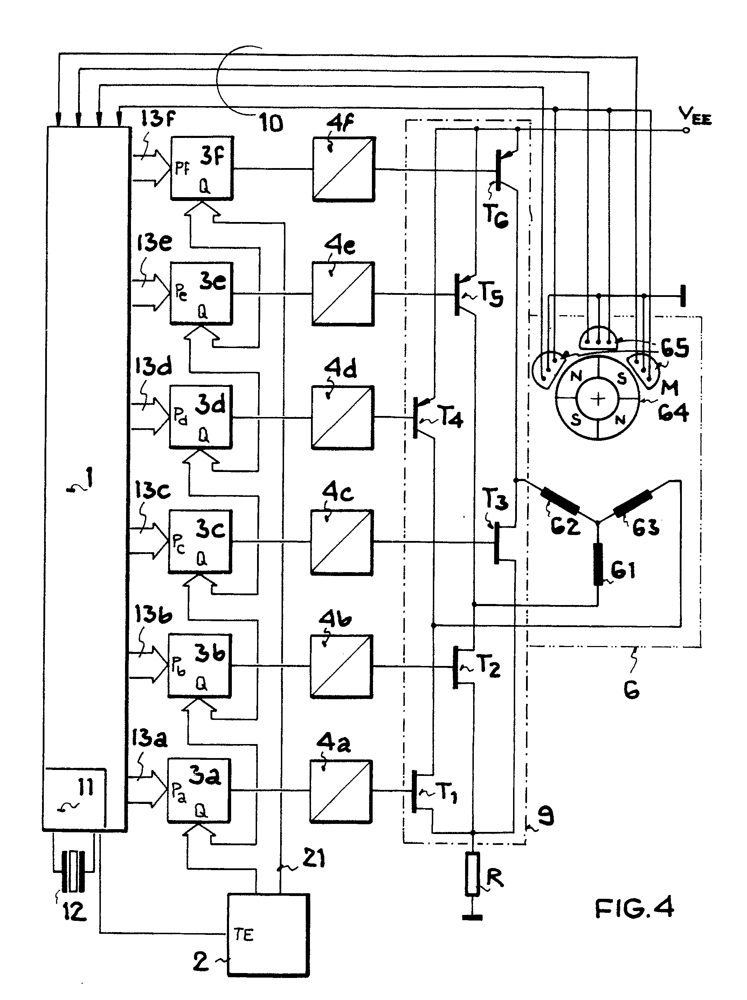

Die Figur 4 zeigt ein weiteres Anwendungsbeispiel der erfindungsgemäßen Schaltungsanordnung, wonach diese Schaltung zum Steuern eines bürstenlosen Gleichstrommotors eingesetzt ist. In diesem die Schaltungsanordnung zeigenden Blockschaltbild ist mit den Bezugszeichen 1, 2, 3a - 3f, 4a - 4f, 6 und 9 eine Motorsteuereinheit, beispielsweise ein Mikroprozessor, ein n-Bit-Zähler, sechs identische digitale Komparatoren, sechs identische Pegelkonverter, ein bürstenloser Gleichstrommotor und eine Treiberstufe bezeichnet. Der bürstenlose Motor 6 besteht aus einer Ankerwicklung, die drei, im Stern geschaltete Stränge 61 - 63 aufweist, einem Rotor 64 mit den Feldmagneten und drei Hallsensoren 65, die zur Detektion der Rotorposition dienen. Die Treiberstufe 9 ist aus drei pnp-Transistoren T4, T5 und T6 sowie aus drei Feldeffekttransistoren T1, T2 und T3 aufgebaut, wobei jeweils ein pnp-Transistor und ein Feldeffekttransistor unter Bildung eines Steuerstranges in Reihe geschaltet sind. Somit werden durch die drei Transistorpaare (T1, T4), (T2, T5) und (T3, T6) drei Steuerstränge gebildet, die ihrerseits parallel geschaltet sind und an einem Ende mit der Betriebsspannungsquelle $V_{EE}$ und am anderen Ende über einen Shuntwiderstand R mit dem Bezugspotential der Schaltung verbunden sind. Die Stränge der Ankerwicklung 61 - 63 sind derart mit den drei Steuersträngen verbunden, daß jeweils der Verbindungspunkt der in Reihe geschalteten Transistoren eines Steuerstranges an einen Strang der Ankerwicklung angeschlossen ist, wodurch der Strom durch den entsprechenden Strang steuerbar ist. Die Basiselektroden der drei pnp-Transistoren T4, T5 und T6 sowie die Steuerelektroden der drei Feldeffekttransistoren T1, T2 und T3 sind jeweils über eine Leitung mit den Pegelkonvertern 4a - 4f verbunden. Die Sensorsignale der Hallsensoren 65 werden über 4 Leitungen 10 der Motorsteuereinheit 1 zur Auswertung zugeführt, um entsprechende Steuersignale über die Leitungen 13a - 13f den Komparatoren 3a bis 3f zuführen zu können. Die Funktion der Komparatoren 3a bis 3f sowie des Zählers 2 entspricht der Funktion des Komparators 3 und des Zählers 2 gemäß der Figur 3, wobei jedoch der Zähler 2 über eine Leitung 21 jedem der Komparatoren 3a - 3f ein Zählwort Q zuführt. Dieses Zählwort Q wird mit dem entsprechenden Steuerwort Pa bzw. Pb... bzw. Pf verglichen, das über die Steuerleitung 13a bzw. 13b bzw. ... bzw. 13f zugeführt wird. Schließlich liefert der Taktgenerator 11 der Motorsteuereinheit 1 dem Zähler das Taktsignal, das auf den Takteingang TE des Zähler gelegt ist. Die Taktfrequenz des Taktgegenerators 11 wird mittels eines Quarzoszillators 12 erzeugt.

Bei den Ausführungsbeispielen gemäß den Figuren 3 und 4 wurde die Bit-Zahl n des Zählers sowie der Steuerdaten nicht spezifiziert. Beispielsweise ergibt sich mit einer Bit-Zahl $n = 8$ die Möglichkeit, 255 Puls-Pausenverhältnisse einzustellen, d.h. für eine Motorsteuerung ergeben sich 255 Einstellungen. Weiterhin ergeben sich mit einer Taktfrequenz $f_T = 10$ MHz eine Schaltfrequenz von ca. 39 kHz. Somit kann mit einem langsamen 8-Bit-Prozessor ein hochfrequentes und hochauflösendes PWM-Signal erzeugt werden.

**Ansprüche**

1) Verfahren zum Erzeugen eines pulsbreitenmodulierten Signals, dadurch gekennzeichnet, daß die in Abhängigkeit von einer Stellgröße erzeugten n-Bit-Steuerdaten (P) mit dem von einem n-Bit-Zähler erzeugten Zählerstand (Q) verglichen werden, daß der Zählvorgang nach Erreichen des Höchstwertes erneut beim niedrigsten Wert beginnt, und daß das Ergebnis des "kleiner als"- oder "größer als"-Vergleichs als digitales Signal im zeitlichen Verlauf das pulsbreitenmodulierte Signal darstellt.

2) Schaltungsanordnung zur Durchführung des Verfahrens nach Anspruch 1, dadurch gekennzeichnet, daß ein die n-Bit-Steuerdaten (P) erzeugender Mikroprozessor (1) und der n-Bit-Zähler (2) mit dem gleichen Taktsignal versorgt werden, daß die n-Bit-Steuerdaten (P) und der Zählerstand (Q) des n-Bit-Zählers (2) zum Vergleich einem digitalen Komparator (3) zugeführt werden, und daß am "kleiner als"- oder "größer als"-Ausgang (31) des digitalen Komparators (3) das pulsbreitenmodulierte Signal vorliegt.

3) Schaltungsanordnung nach Anspruch 2, dadurch gekennzeichnet, daß ein Taktgenerator (11) des Mikroprozessors (1) dem n-Bit-Zähler (2) das Taktsignal zuführt.

4) Schaltungsanordnung nach Anspruch 2 oder 3, dadurch gekennzeichnet, daß das pulsbreitenmodulierte Signal des Komparators (3) einem Pegelumsetzer (4) zugeführt wird.

| 3 - BIT | | P > Q ? | PWM-SIGNAL |
|---|---|---|---|
| STEUERDATEN<br><br>P | ZÄHLER<br>ZÄHLERSTAND<br><br>Q | JA /NEIN | L / H |
| 1 | 0<br>1<br>.<br>.<br>.<br>7 | J<br>  N<br>. .<br>  .<br>. .<br>    N |     H<br>L<br> .<br> .<br>L |
| 3 | 0<br>1<br>2<br>3<br>.<br>.<br>7 | J J J<br>   N<br> . .<br>  .<br>   N |    H H<br>   H<br>L<br> .<br> .<br>L |

FIG.1

FIG.2

FIG.3

FIG.4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4365202 (J.O.SINNIGER) <br> * Spalte 2, Zeilen 48 - 60 * <br> * Anspruch 1; Figuren 1-3 * | 1 | H03K3/017 <br> H03K7/08 <br> H02P7/00 |
| Y | * Spalte 2, Zeilen 46 - 48 * <br> --- | 2-4 | |
| Y | EP-A-94763 (TOKYO SHIBAURA D.K.K.) <br> * Seite 3, Zeilen 21 - 25; Figuren 1, 2 * <br> --- | 2-4 | |
| X <br> A | GB-A-2038520 (J.L.FEAVER) <br> * Zusammenfassung; Figur 1 * <br> * Seite 2, Zeilen 50 - 59 * <br> ----- | 1 <br> 2 | |
| | | | **RECHERCHIERTE SACHGEBIETE (Int. Cl.5)** <br><br> H03K <br> H02P |

Der vorliegende Recherchenbericht wurde für alle Patentansprüche erstellt

| Recherchenort | Abschlußdatum der Recherche | Prüfer |
|---|---|---|
| BERLIN | 22 OKTOBER 1990 | LEOUFFRE, M |

EPO FORM 1503 03.82 (P0403)